# EUROPEAN PATENT SPECIFICATION

(11) **EP 3 049 547 B1**
(45) Date of publication and mention of the grant of the patent: **16.01.2019**
(21) Application number: 14849171.5
(22) Date of filing: 16.09.2014
(51) Int. Cl.: C23C 10/04, C23C 10/06, C23C 10/08, C23C 10/20, C23C 14/04, C23C 14/24

(54) **METHOD OF SIMULTANEOUSLY APPLYING THREE DIFFERENT DIFFUSION ALUMINIDE COATINGS TO A SINGLE PART**
VERFAHREN ZUM GLEICHZEITIGEN AUFTRAGEN VON DREI VERSCHIEDENEN DIFFUSION- ALUMINIUMBESCHICHTUNGEN AUF EINEN EINZELARTIKEL
PROCÉDÉ D'APPLICATION SIMULTANÉE DE TROIS REVÊTEMENTS DIFFÉRENTS DE COMPOSÉ D'ALUMINIUM PAR DIFFUSION SUR UNE SEULE PIÈCE

(30) Priority: 24.09.2013 US 201361881732 P
(43) Date of publication of application: 03.08.2016
(73) Proprietor: United Technologies Corporation, Farmington, CT 06032 (US)
(72) Inventor: LIVINGS, Mark A., East Windsor, Connecticut 06088 (US)
(74) Representative: Dehns
(86) International application number: PCT/US2014/055771
(87) International publication number: WO 2015/047783

(56) References cited:
- EP-A1- 1 790 753
- WO-A2-01/98561
- US-A- 5 702 288
- US-A- 5 824 366
- US-A- 5 824 366
- US-A1- 2009 126 833
- US-A1- 2010 266 417
- US-B1- 6 273 678
- US-B2- 6 730 179
- NOWOTNIK ET AL.: 'Microstructure and kinetic growth of aluminide coatings deposited by the CVD method on Re 80 superalloy' ARCHIVES OF MATERIAL SCIENCE AND ENGINEERING vol. 55, no. IS. 1, 22 May 2012, XP055334547

## Description

### BACKGROUND

The present invention relates to methods for coating metal components, such as aerospace components. In particular, the present invention relates to methods for forming diffusion aluminide coatings on external surfaces and internal passageways that provide corrosion and oxidation resistance.

A gas turbine engine typically consists of an inlet, a compressor, a combustor, a turbine and an exhaust duct. The compressor draws in ambient air and increases its temperature and pressure. Fuel is added to the compressed air in the combustor where it is burned to raise gas temperature, thereby imparting energy to the gas stream. To increase gas turbine engine efficiency, it is desirable to increase the temperature of the gas entering the turbine. This requires the first stage turbine vanes and rotor blades to be able to withstand the thermal and oxidation conditions of the high temperature combustion gas during the course of operation.

To protect the first stage turbine vanes and rotor blades from extreme conditions, such components typically include coatings (e.g. aluminide coatings) that provide oxidation and corrosion resistance. Different aluminide coatings are applied from different solid and vapor sources using separate operations for each coating type.

### SUMMARY

A method of simultaneously applying three different diffusion aluminide coatings to a metal part with an external surface and internal passageways as described in claim 1, includes first placing the part in an enclosed retort. Areas of the part are then coated with aluminum containing slurry for a first diffusion aluminide coating. Interior walls of the retort are then coated with a vapor source slurry for a second vapor phase aluminum coating on the surface of the part. Areas on the surface of the part not requiring coating are coated with masking materials. A closed chamber inside the retort containing source material for a third vapor phase diffusion aluminide coating for the internal passageways is then attached to the internal passageways. The retort is then placed in a furnace under a protective atmosphere and subjected to diffusion heat treat to coat the external surfaces and internal passageways with the three different aluminide coatings.

### BRIEF DESCRIPTION OF THE DRAWINGS

FIG. 1 is a schematic of a turbine blade with internal passageways.
FIG. 2 is a schematic of a coating apparatus of the invention.
FIG. 3 is a description of the coating process of the invention.

### DETAILED DESCRIPTION

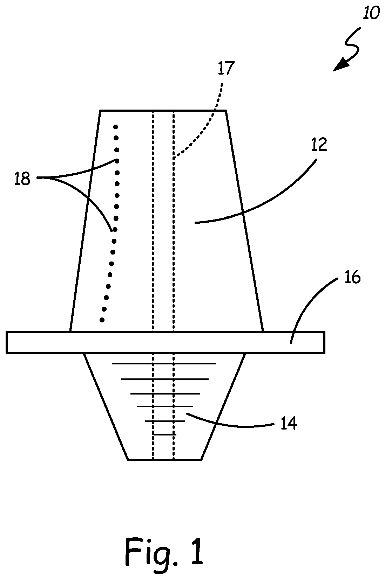

FIG. 1 is a schematic illustration of a blade, in this example, a turbine blade which could be subject to the method of claim 1. In other examples, blade 10 may be a vane, nozzle, or other gas path component known in the art. Turbine blade 10 is comprised of airfoil 12, root 14 (used to attach the blade to a rotatable turbine disc) and platform 16 located between the airfoil and root. Blade 10 may have internal passageways 17 through which engine air is directed to cool the blade during operation in the hot gas path of a turbine engine. Cooling holes 18 may be connected to the internal passageways wherein the cooling air emerges as a gas film to further cool the blade during operation. Turbine blades and vanes particularly in high pressure turbines (HPT) and low pressure turbines (LPT) require coatings to protect the components from the oxidative and erosive environment of the gas path. In an example, blade 10 may be a Ni base, Co base, Fe base superalloy or mixtures thereof. It should be understood that the invention is not limited to blades and vanes and that other turbine components are included.

One family of coatings comprises aluminum containing aluminide coatings wherein the intermetallic phase beta - NiAl forms on the surface of a component. NiAl is highly oxidation resistant and also acts as a supplier of aluminum atoms to form a protective aluminum oxide layer on the surface of the component. The aluminum coatings typically contain Cr, Ti, Ni, and/or Si. The alloying elements control the activity of aluminum during coating. Low activity coatings form via the outward diffusion of solutes from the underlying component into an aluminum containing layer deposited on the component to form a coating. More specifically, Ni diffuses out to an aluminum rich deposited layer to form NiAl during a diffusion anneal. Outward type coatings are characterized by a two zone microstructure known to those in the art. High activity coatings form via inward diffusion of aluminum into the component to form NiAl during the diffusion anneal. Both high and low activity aluminide coatings rely on a carrier such as a complex aluminum halide or an alkali or alkaline earth metal to transport the aluminum to the substrate in the form of a gas wherein upon contact the carrier gas reacts to deposit aluminum on the surface. This process is discussed in US Patent No. 4,132,816 to Benden et al. Inward type diffusion aluminide coatings may be deposited directly from a slurry containing an aluminum alloy source and a binder or from a slurry containing an aluminum alloy source, a halide activator and a binder. Inward type coatings have a three zone microstructure known to those in the art. Outward type diffusion aluminide coatings may be formed by vapor phase aluminiding (VPA) wherein the aluminiding vapor source may be a slurry containing an aluminum alloy source, a halide activator and a binder, or a concentration of vapor source material in the form of particles or pellets containing an aluminide alloy and a halide activator. In both cases, the slurry and particles are composed of an aluminum alloy source of aluminum, a halide activator that forms an aluminum halide gas or a complex aluminum halide gas and, in the case of the slurry, a binder, typically an organic solution.

Both inward type and outward type aluminide coatings may be formed from a slurry applied directly to a part and subsequently dried. The thickness of an aluminide coating as known in the art depends on the slurry composition, thickness, diffusion temperature, and time. High activity coatings such as PWA 73 and PWA 273, as described in US Patent No. 5,366,765 to Milaniak, form inward type coatings. An aluminum alloy source may be an intermetallic compound such as Co₂Al₅ and the activator may be ammonium chloride. Outward type diffusion aluminide coatings are a low activity coating such as PWA 545 as described in US Patent Nos. 6,022,362 and 6,045,863 to Olsen et al. The aluminum source may be pure aluminum and the activator may be aluminum trifluoride. EP1790753 discloses a method of forming different diffusion aluminide coatings on different regions of a component.

Coating separate areas of the surface of a component with different diffusion aluminide coatings with different thicknesses and microstructures usually involve multiple thermal cycles. If two or more areas on a single component could be coated with different diffusion aluminide coatings in a single operation, significant time, cost and energy savings would be accomplished. In the present invention, three separate areas of a turbine component including outside surface areas and interior passageways are coated with three different diffusion aluminide coatings in a single operation.

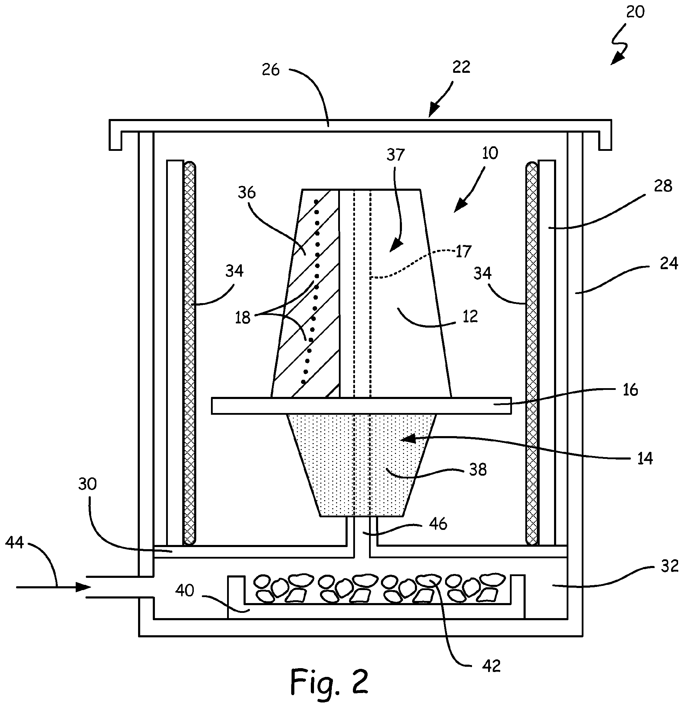

A schematic illustrating the method of the present invention is shown in FIG. 2. Apparatus 20 comprises turbine blade 10 positioned in retort 22. Retort 22 comprises retort wall 24 and lid 26 creating a closed chamber for applying the diffusion aluminide coatings of the invention to blade 10.

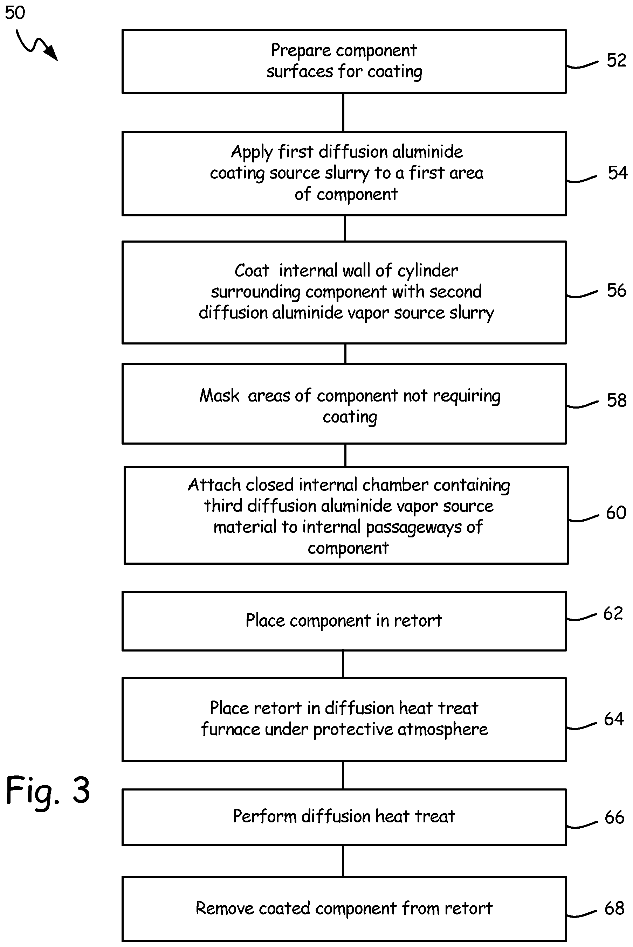

With reference to FIG. 2, coating process 50 is shown in FIG. 3. The surfaces of blade 10 are first prepared for coating by mechanical and chemical cleaning procedures known in the art. (Step 52).

A first diffusion aluminide coating source slurry is then directly applied to certain areas of blade 10 such as area 36 in FIG. 2 (Step54). The inner walls of cylinder 28 on support 30, surrounding blade 10 in retort 22 are then coated with second diffusion aluminide vapor source slurry 34 (Step 56). Vapor from vapor source 34 on the inside wall of cylinder 28 will coat area 37 on blade 12. Outside areas of blade 10 not requiring diffusion aluminide coating are masked with masking material (Step 58). In FIG. 2, root 14 of blade 10 is covered with masking material 38. As shown in FIG. 2, blade 10 is positioned such that internal passageways 17 of blade 10 are attached to closed chamber 32. Closed internal chamber 32 contains receptacle 40 containing diffusion aluminide vapor source material 42 for coating the internal passageway surfaces (Step 60). An inert carrying gas entering closed internal chamber 32 as indicated by arrow 44 transports the aluminizing vapor through port 46 in support 30 into the internal passageways 17 of blade 10.

Blade 10 is then placed in retort 22 as shown in FIG. 2. Apparatus 20 is then placed in a diffusion heat treat furnace under a protective atmosphere. (Step 69). In one embodiment, apparatus 20 is heated to about 1255 K (1800° F) to about 13422 K (2100° F) for from about 2 hours to about 10 hours in an argon atmosphere and removed from the furnace and cooled under argon. (Step 66).

During the diffusion heat treatment, area 36 on blade 10 will be coated with an aluminide coating by the slurry directly applied to that area. In an embodiment, area 36 may be coated with an inward type aluminide coating. Outside areas 37 not coated with a slurry or a maskant (area 38) will be coated with vapor emanating from vapor source slurry 34 coated on cylinder wall 28. In an embodiment, these areas may be coated with an outward type low activity aluminide coating. At the same time, carrier gas 44 entering closed chamber 32 carries aluminizing vapor from vapor source material 42 into internal passageways 17 of blade 10 through port 46 in support 30. In an embodiment, the diffusion aluminide coating on the internal passageways may be an outward type coating.

Following the diffusion anneal, the retort is removed from the furnace and the component is removed from the retort (Step 68).

Discussion of Possible Embodiments

The following are non-exclusive descriptions of possible embodiments of the present invention.

A method of simultaneous application of three different diffusion aluminide coatings to a metal part with an external surface and internal passageways may include: placing the part in a retort; applying an aluminum containing source slurry for a first diffusion aluminide coating to a first area of the external surface of the part; coating the interior walls of the retort with a vapor phase coating source slurry for a second vapor phase aluminide coating on a second surface of the part; masking areas not requiring diffusion aluminide coating with masking material; and attaching a closed chamber inside the retort containing source material for a third vapor phase diffusion aluminide coating to the internal passageways of the part.

The retort is placed in a furnace under a protective atmosphere and a diffusion heat treat is performed to coat the external surface and internal passageways of the part with the three diffusion aluminide coatings.

The aluminide coatings may include outward type and inward type coatings. The diffusion heat treat is between about 1255 K (1800° F) and about 1422 K (2100° F).

The diffusion heat treat is for a period of between about 2 hours and about 10 hours.

The first diffusion aluminide coating is an inward type coating.

The second vapor phase diffusion aluminide coating may be an outward type coating.

The third vapor phase diffusion aluminide coating is an outward type coating.

The part may be a turbine component.

The component may be a blade or a vane.

The metal may be a nickel-based, cobalt-based, iron-based superalloy or mixtures thereof.

A metal part with first and second outside surface areas and internal passageways wherein the first and second outside surface areas and the internal passageways are ready to be coated with different diffusion aluminide coatings formed during a single diffusion heat treatment may include: a first outside surface area coated with an inward type diffusion aluminide coating; a second outside surface area coated with an outward type diffusion aluminide coating; and internal passageways coated with an outward type diffusion aluminide coating.

The metal part of the preceding paragraph may optionally include, additionally and/or alternatively any, one or more of the following features, configurations and/or additional components:
The part may be in a closed retort.

Areas not requiring aluminide coating may be masked with masking material.

The inward type diffusion aluminide coating on the first outside area may be formed from a coating source slurry directly applied to the first outside surface area.

The outward type diffusion aluminide coatings on the internal passageways may be formed from vapor supplied from a vapor source slurry material in a closed internal chamber in the closed retort.

The diffusion heat treat may be between about 1255 K (1800° F) and about 1422 K (2100° F).

The diffusion heat treat may be for a period of between about 2 hours and about 10 hours.

The part may be a turbine component.

The metal may be a nickel-based, cobalt-based, iron-based superalloy or mixtures thereof.

## Claims

1. A method of simultaneous application of three different diffusion aluminide coatings to a metal part with an external surface and internal passageways, the method comprising:
placing the part in a retort (22);
applying an aluminum containing source slurry for a first diffusion aluminide coating to a first area (36) of the external surface of the part;
coating the interior walls of the retort (22) with a vapor phase coating source slurry for a second vapor phase diffusion aluminide coating on a second surface of the part;
masking areas not requiring diffusion aluminide coating with masking material (38); and
attaching a closed chamber inside the retort (22) containing source material for a third vapor phase diffusion aluminide coating to the internal passageways of the part;
wherein the retort (22) is placed in a furnace under a protective atmosphere and a diffusion heat treat is performed to coat the external surface and internal passageways (17) of the part with the three diffusion aluminide coatings;
wherein the diffusion heat treat is between about 1255 K (1800 °F) and about 1422 K (2100 °F);
wherein the diffusion heat treat is for a period of between about 2 hours and about 10 hours;
wherein the first diffusion aluminide coating is an inward type coating;
wherein the second vapor phase diffusion aluminide coating is an outward type coating;
wherein the third vapor phase diffusion aluminide coating is an outward type coating.

2. The method of claim 1 wherein the aluminide coatings comprise outward type and inward type coatings.

3. The method of claim 1 wherein the part is a turbine component.

4. The method of claim 3, wherein the component is a blade (10) or a vane.

5. The method of claim 1 wherein the metal is a nickel-based, cobalt-based, iron-based superalloy or mixtures thereof.

## Patentansprüche

1. Verfahren zum gleichzeitigen Auftragen von drei verschiedenen Diffusion-Aluminiumbeschichtungen auf einen Metallartikel mit einer Außenfläche und inneren Durchlässen, das Verfahren Folgendes umfassend:
Platzieren des Artikels in eine Retorte (22);
Auftragen eines Aluminium enthaltenden Quellschlamms für eine erste Diffusion-Aluminiumbeschichtung auf einen ersten Bereich (36) der Außenfläche des Artikels;
Beschichten der Innenwände der Retorte (22) mit einem Dampfphasen-Beschichtungsquellschlamm für eine zweite Dampfphasen-Diffusion-Aluminiumbeschichtung auf einer zweiten Fläche des Artikels;
Maskieren von Bereichen mit Maskierungsmaterial (38), die keine Diffusion-Aluminiumbeschichtung benötigen;
und
Anbringen einer geschlossenen Kammer in der Retorte (22), die Ausgangsmaterial für eine dritte Dampfphasen-Diffusion-Aluminiumbeschichtung für die inneren Durchlässe des Artikels enthält;
wobei die Retorte (22) in einem Ofen unter einer Schutzatmosphäre platziert und eine Diffusionshitzebehandlung durchgeführt wird, um die Außenfläche und die inneren Durchlässe (17) des Artikels mit den drei Diffusion-Aluminiumbeschichtungen zu beschichten;
wobei die Diffusionshitzebehandlung zwischen etwa 1255 K (1800 °F) und etwa 1422 K (2100 °F) liegt;
wobei die Diffusionshitzebehandlung für einen Zeitraum zwischen ca. 2 Stunden und ca. 10 Stunden ist;
wobei die erste Diffusion-Aluminiumbeschichtung eine Beschichtung des nach innen gerichteten Typs ist;
wobei die zweite Dampfphasen-Diffusion-Aluminiumbeschichtung eine Beschichtung des nach außen gerichteten Typs ist;
wobei die dritte Dampfphasen-Diffusion-Aluminiumbeschichtung eine Beschichtung des nach außen gerichteten Typs ist.

2. Verfahren nach Anspruch 1, wobei die Aluminiumbeschichtungen Beschichtungen des nach innen gerichteten Typs und Beschichtungen des nach außen gerichteten Typs umfassen.

3. Verfahren nach Anspruch 1, wobei der Artikel eine Turbinenkomponente ist.

4. Verfahren nach Anspruch 3, wobei die Komponente eine Schaufel (10) oder ein Flügel ist.

5. Verfahren nach Anspruch 1, wobei das Metall eine nickelbasierte Superlegierung, kobaltbasierte Superlegierung, eisenbasierte Superlegierung oder Kombinationen daraus ist.

## Revendications

1. Procédé d'application simultanée de trois revêtements différents d'aluminiure de diffusion sur une pièce métallique ayant une surface externe et des voies de passage internes, le procédé comprenant :
le placement de la pièce dans une cornue (22) ;
l'application d'une suspension source contenant de l'aluminium pour un premier revêtement d'aluminiure de diffusion sur une première zone (36) de la surface externe de la pièce ;
le revêtement des parois internes de la cornue (22) avec une suspension source de revêtement en phase vapeur pour un deuxième revêtement d'aluminiure de diffusion en phase vapeur sur une seconde surface de la pièce ;
le masquage de zones n'ayant pas besoin d'un revêtement d'aluminiure de diffusion avec un matériau de masquage (38) ;
et
la fixation d'une chambre fermée à l'intérieur de la cornue (22) contenant un matériau source pour un troisième revêtement d'aluminiure de diffusion en phase vapeur aux voies de passage internes de la pièce ;
dans lequel la cornue (22) est placée dans un four sous une atmosphère protectrice et un traitement thermique par diffusion est effectué pour revêtir la surface externe et les voies de passage internes (17) de la pièce avec les trois revêtements d'aluminiure de diffusion ;
dans lequel le traitement thermique par diffusion est entre environ 1 255 K (1 800 °F) et environ 1 422 K (2 100 °F) ;
dans lequel le traitement thermique par diffusion est pendant une période située entre environ 2 heures et environ 10 heures ;
dans lequel le premier revêtement d'aluminiure de diffusion est un revêtement de type intérieur ;
dans lequel le deuxième revêtement d'aluminiure de diffusion en phase vapeur est un revêtement de type extérieur ;
dans lequel le troisième revêtement d'aluminiure de diffusion en phase vapeur est un revêtement de type extérieur.

2. Procédé selon la revendication 1 dans lequel les revêtements d'aluminiure comprennent des revêtements de type extérieur et de type intérieur.

3. Procédé selon la revendication 1 dans lequel la pièce est un composant de turbine.

4. Procédé selon la revendication 3, dans lequel le composant est une ailette (10) ou une aube.

5. Procédé selon la revendication 1 dans lequel le métal est un superalliage à base de nickel, à base de cobalt, à base de fer, ou un mélange de ceux-ci.
